(19) Europäisches Patentamt
European Patent Office
Office européen des brevets

(11) **EP 2 509 221 B1**

(12) **FASCICULE DE BREVET EUROPEEN**

(45) Date de publication et mention
de la délivrance du brevet:
**18.06.2014 Bulletin 2014/25**

(51) Int Cl.:
*H03H 7/01* *(2006.01)*          *H03H 9/15* *(2006.01)*
*H03H 9/46* *(2006.01)*

(21) Numéro de dépôt: **12161992.8**

(22) Date de dépôt: **29.03.2012**

(54) **Dispositif utilisant un filtre à base de résonateurs**

Schaltung mit Resonator Filters

Device using a resonator based filter

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **07.04.2011 FR 1153038**

(43) Date de publication de la demande:
**10.10.2012 Bulletin 2012/41**

(73) Titulaire: **COMMISSARIAT A L'ENERGIE
ATOMIQUE ET AUX
ENERGIES ALTERNATIVES
75015 Paris (FR)**

(72) Inventeurs:
• **BERNIER, Carolynn**
  **38000 GRENOBLE (FR)**
• **DAVID, Jean-Baptiste**
  **38000 GRENOBLE (FR)**

(74) Mandataire: **Guérin, Michel
Marks & Clerk France
Conseils en Propriété Industrielle
Immeuble Visium
22, Avenue Aristide Briand
94117 Arcueil Cedex (FR)**

(56) Documents cités:
**WO-A2-2004/066490      US-A- 2 216 937
US-A- 2 249 415        US-A1- 2003 128 081**

**Description**

L'invention concerne les circuits utilisant des filtres à base de résonateurs, et plus particulièrement des filtres de signaux électriques dans la bande UHF, de quelques centaines de MHz à quelques GHz.

Il existe un nombre de plus en plus important d'applications portables qui exploitent un système de communication par radiofréquence pour l'échange de données entre différents noeuds. Les contraintes de réalisation sont souvent des contraintes de faible consommation en particulier lorsqu'ils sont alimentés par des piles ou des systèmes de récupération d'énergie ambiante.

Du fait de l'augmentation du nombre des applications, les bandes de fréquence UHF autour de 2,4 GHz qui sont souvent employées par ces systèmes, notamment pour des applications industrielles, scientifiques et médicales, sont de plus en plus encombrées, augmentant ainsi le nombre de signaux interférents pouvant saturer l'entrée du récepteur. Pour se prémunir contre ces interférences, le concepteur du système a le choix soit d'augmenter la linéarité du récepteur, généralement au prix d'une augmentation de sa consommation électrique, soit d'augmenter sa sélectivité, et ceci idéalement très en amont dans la réception donc le plus près possible de l'antenne. Cette deuxième approche crée donc un besoin de filtres passe-bandes centrés sur les fréquences UHF, de bande passante relativement étroite (de l'ordre de la largeur réservée à un canal dans la répartition de fréquences autorisées) et pouvant être mis en place dans le récepteur avec un impact minimal sur la consommation électrique de celui-ci.

Or, la nécessité de travailler directement aux fréquences UHF exclut l'utilisation de techniques de filtrage actif typiquement utilisées à des fréquences plus faibles. On cherche donc à utiliser des résonateurs passifs fonctionnant directement aux fréquences UHF, basés par exemple sur des technologies SAW ou BAW (de l'anglais Surface Acoustic Wave ou Bulk Acoustic Wave) qui sont des résonateurs à onde de surface ou à onde de volume.

De tels résonateurs peuvent être utilisés soit comme résonateurs individuels associés à un circuit actif qui bénéficie ainsi de la sélectivité en fréquence du résonateur autour de sa fréquence de résonance ou d'antirésonance, soit comme un ensemble de résonateurs individuels séparés les uns des autres par des éléments actifs, soit encore comme résonateurs dans un filtre purement passif lui-même associé à un circuit d'entrée et un circuit de sortie, chacun de ces deux circuits pouvant être actif ou passif. Or, les fonctions de filtrage obtenues avec des résonateurs individuels ont une sélectivité limitée et ne fournissent pas toujours une bande passante suffisamment plate dans la bande utile. De leur côté, les circuits actifs rendent la structure plus consommatrice d'énergie, ce qu'on ne souhaite pas.

Dans l'art antérieur, on a déjà proposé des filtres passifs basés sur une ou plusieurs cellules en treillis (aussi connus sous la dénomination anglaise "lattice filter") à entrée et sortie différentielles, chaque cellule employant quatre résonateurs connectés de manière « directe » et « croisée » entre l'entrée et la sortie de la cellule. Deux types de résonateurs sont classiquement utilisés pour réaliser des résonateurs « série » ou « parallèle ». Chaque résonateur a une impédance caractéristique Zc et présente à la fois une fréquence de résonance (Fr) et une fréquence d'antirésonance (Fa) avec Fa>Fr. Les fréquences de résonance d'un type de résonateur sont différentes de celles de l'autre type, et il en est de même des fréquences d'antirésonance. Classiquement, on s'arrange pour que la fréquence de résonance des résonateurs d'un premier type soit égale à la fréquence d'antirésonance du second type, pour obtenir une bande passante suffisamment plate autour de la fréquence centrale de la bande.

Ces filtres en treillis sont placés entre un circuit d'entrée et un circuit de sortie, et il est généralement admis qu'on adapte l'impédance du circuit d'entrée à l'impédance du filtre vu du côté de son entrée lorsqu'il est chargé par un circuit de sortie, et de même on adapte l'impédance du circuit de sortie à l'impédance du filtre vue de sa sortie lorsque ses entrées sont connectées au circuit d'entrée ; la raison de cette adaptation est l'optimisation du transfert en puissance du signal.

Les impédances d'entrée et de sortie du filtre, ainsi que l'impédance caractéristique de chacun des résonateurs sont le plus souvent choisies avec une valeur commune standard. Les valeurs communes standard sont le plus souvent 50 ohms, 100 ohms et possiblement 200 ohms (notamment pour des fonctionnements différentiels).

Un exemple de résonateur particulièrement bien adapté aux systèmes de transmission radiofréquence est le résonateur à onde acoustique de volume (« Bulk Acoustic Wave », BAW) qui permet d'obtenir des résonances à des fréquences de l'ordre de 800 MHz à 3GHz correspondant aux bandes UHF couramment employées dans les systèmes de télécommunication modernes. Par exemple le résonateur est constitué par un substrat évidé en face arrière, une membrane de support au-dessus de l'évidement, et une couche de matériau piézoélectrique prise en sandwich entre deux électrodes métalliques. L'ajustement de la fréquence de résonance de ce résonateur peut être obtenu en chargeant l'empilement de couches par une couche supplémentaire qui rajoute une masse à l'empilement et qui diminue donc les fréquences de résonance et d'antirésonance..

Ces résonateurs ont un fort facteur de qualité et ils sont de très faible taille. Ils ne sont cependant pas faciles à utiliser lorsqu'on veut obtenir à la fois une très faible bande passante, une bande plate dans la bande utile, et une faible consommation de la structure de filtrage qui incorpore les résonateurs.

Un objectif de la présente invention est de proposer une nouvelle structure de filtrage basée sur des résonateurs passifs fonctionnant aux fréquences UHF, permettant d'atteindre les faibles bandes passantes souhaitées, sans ondulation dans la bande, et tout en autorisant une faible consommation électrique des circuits associés à l'entrée et à la sortie du filtre. Un but de l'invention est également d'obtenir une structure de filtrage ayant une courbe de réponse en fréquence plus plate dans la bande utile que ce que permettent les structures utilisant un unique résonateur.

Selon l'invention on propose un dispositif de filtrage comportant un circuit électronique d'entrée ayant une admittance de sortie Yin, un circuit électronique de sortie ayant une admittance d'entrée Yout, un filtre présentant une entrée différentielle reliée au circuit d'entrée, et une sortie différentielle reliée au circuit de sortie, le filtre comprenant plusieurs résonateurs de deux types connectés entre l'entrée et la sortie du filtre, les résonateurs du premier type ayant une fréquence de résonance Fr1 et une fréquence d'antirésonance Fa1, et les résonateurs du deuxième type ayant une fréquence de résonance Fr2 et une fréquence d'antirésonance Fa2 respectivement différentes de Fr1 et Fa1, **caractérisé en ce que** l'inverse de la partie réelle de l'admittance Yin (1/Re{Yin}) et l'inverse de la partie réelle de l'admittance Yout (1/Re{Yout}) sont supérieures à k fois la valeur de la moyenne géométrique des impédances caractéristiques (Zc) des résonateurs, k étant un nombre au moins égal à 2, et en ce que les différences de fréquence Fa1-Fr1 et Fa2-Fr2 sont supérieures à k' fois la valeur absolue de la différence Fr2-Fr1, k' étant un nombre au moins égal à 2.

De préférence, la différence entre la fréquence de résonance et la fréquence d'antirésonance est la même (approximativement) pour les résonateurs des deux types.

De préférence aussi, le module de l'admittance de sortie du circuit d'entrée est égal au module de l'admittance d'entrée du circuit de sortie.

Le nombre k est de préférence supérieur ou égal à 5. Le nombre k' est de préférence supérieur ou égal à 3.

De préférence, le filtre comprend au moins une cellule en treillis constituée de quatre résonateurs, deux résonateurs du premier type et deux résonateurs du second type, montés de manière croisée entre deux bornes de l'entrée différentielle et deux bornes de la sortie différentielle du filtre.

Selon un aspect de l'invention, on couple donc un filtre en treillis, ayant deux types de résonateurs, avec un circuit électrique d'entrée et un circuit électrique de sortie, ces deux circuits possédant respectivement une forte impédance de sortie et d'entrée, plutôt que de chercher à utiliser comme on le fait classiquement des circuits d'entrée et de sortie ayant des impédances adaptées à l'impédance caractéristique des résonateurs. En réduisant en même temps l'écart entre les fréquences de résonance des deux types de résonateurs, on obtient la bande passante désirée pour le filtre sans risquer une atténuation (qu'on aurait nécessairement si on réduisait cet écart alors qu'on est dans une configuration classique avec des impédances adaptées). On constate qu'on peut obtenir une bande passante relativement plate et étroite tout en bénéficiant de la réduction de la consommation électrique des circuits d'entrée et sortie grâce aux niveaux élevés d'impédances.

En résumé, alors qu'une configuration classique de dispositif de filtrage à filtre en treillis utiliserait normalement des impédances adaptées en entrée et en sortie et une coïncidence approximative entre la fréquence de résonance d'un type de résonateurs et la fréquence d'antirésonance de l'autre type, l'invention propose une configuration avec des impédances fortement désadaptées, et une forte réduction de l'écart entre les fréquences de résonance des deux types de résonateurs.

D'autres caractéristiques et avantages de l'invention apparaîtront à la lecture de la description détaillée qui suit et qui est faite en référence aux dessins annexés dans lesquels :

- la figure 1 représente une structure de résonateur à onde de volume utilisable dans l'invention ;
- la figure 2 représente un circuit électrique équivalent simplifié du résonateur autour de sa résonance principale ;
- la figure 3 représente le module de l'impédance du résonateur en fonction de la fréquence avec un minimum à sa fréquence de résonance et un maximum à sa fréquence d'antirésonance ;
- la figure 4 représente un filtre constitué d'une cellule en treillis à quatre résonateurs utilisé dans l'invention ;
- la figure 5 représente le module du coefficient de transmission d'un filtre en treillis de l'art antérieur chargé par des impédances d'entrée et de sortie adaptées ;
- la figure 6 représente le module de la charge équivalente d'un filtre pour deux valeurs différentes de l'impédance d'entrée et de sortie (270 ohms et 1000 ohms) ;
- la figure 7 représente le module de la charge équivalente pour une impédance d'entrée et de sortie de 1000 ohms, lorsque l'écart entre les fréquences de résonance des deux types de résonateurs du filtre prend deux valeurs différentes ;
- la figure 8 représente le module de la charge équivalente dans une structure classique et dans une structure de filtrage selon l'invention ;
- la figure 9 représente une courbe de variation de l'écart de fréquence souhaitable en fonction de l'impédance d'entrée ou de sortie pour un filtre réalisé avec des résonateurs issus d'une technologie BAW standard et centré à 2350MHz ;
- la figure 10 représente une comparaison de courbes de réponse en fonction de la fréquence pour l'invention et pour un filtre à résonateur unique lorsque l'on fait varier le facteur de qualité de ce dernier de 200 à 1000 ;
- la figure 11 représente un schéma de la structure de filtrage où le circuit d'entrée est représenté par son équivalent de type Norton.

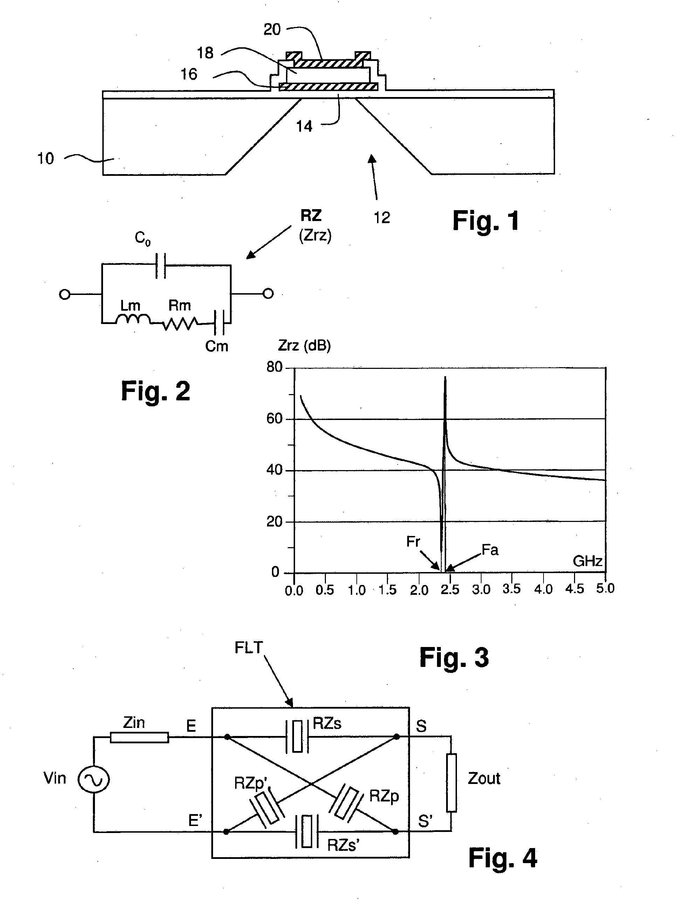

Sur la figure 1 on a représenté schématiquement la construction matérielle d'un exemple de résonateur à ondes acoustiques de volume, dans sa configuration dite FBAR ("Film Bulk Acoustic Resonator" ou résonateur acoustique en volume à membrane) . La vue est une vue en coupe. Un substrat 10 porte au-dessus d'un évidement 12 une membrane 14 et, sur celle-ci, un empilement de plusieurs couches constituant le résonateur proprement dit. L'empilement comprend au moins une électrode inférieure 16, une couche piézoélectrique 18, et une électrode supérieure 20. La couche piézoélectrique 18 est représentée comme une couche unique mais peut être composée de plusieurs couches. Les dimensions latérales de l'empilement de couches, hors du plan de coupe, peuvent être de plusieurs dizaines de micromètres de côté pour une épaisseur de l'ordre du micromètre. La forme en vue de dessus est de préférence carrée ou à peu près carrée. Le mode de réalisation FBAR présenté sur la figure 1 n'est pas exclusif au regard de la présente invention, et pourrait être remplacé par une configuration de type SMR ("Solidly Mounted Resonator" ou résonateur à montage solide) reposant sur l'usage d'un réflecteur acoustique, si l'on demeurait dans le domaine des ondes acoustiques de volume.

Autour de sa résonance principale, un résonateur RZ de ce type peut être modélisé par un schéma équivalent électrique constitué d'une capacité $C_0$ en parallèle avec un ensemble série d'une inductance Lm, une résistance Rm, et une autre capacité Cm, conformément au schéma de la figure 2. Il a une impédance Zrz entre ses bornes, variable avec la fréquence.

Le résonateur présente une fréquence de résonance Fr et une fréquence d'antirésonance Fa. La fréquence de résonance est proche de la fréquence d'antirésonance et est plus faible qu'elle. Le module de l'impédance |Zrz| du circuit équivalent au résonateur varie avec la fréquence selon la courbe de la figure 3 où |Zrz| est représenté en décibels $(20\log(|Zrz|))$. La figure 3 montre clairement la fréquence de résonance pour laquelle l'impédance tend vers zéro et la fréquence d'antirésonance pour laquelle l'impédance devient très élevée.

L'impédance caractéristique Zc d'un résonateur est donnée par $1/2\pi F_0 C_0$ où $F_0$ est la fréquence centrale de fonctionnement, entre la fréquence de résonance et la fréquence d'antirésonance. Elle dépend donc principalement de la valeur de la capacité équivalente $C_0$.

Cette capacité $C_0$ est liée aux données technologiques de fabrication ainsi qu'au facteur de forme (épaisseur/dimension latérale) de l'empilement de couches, la capacité étant proportionnelle au rapport entre la surface du résonateur et l'épaisseur de la couche piézoélectrique.

Aux fréquences de l'ordre de 2 GHz qui présentent un intérêt important, l'impédance caractéristique du plus petit résonateur peut difficilement dépasser 200 ohms si le résonateur respecte un facteur de forme minimum d'environ 2% ; au dessus de 2%, il apparaîtrait des modes de propagation indésirables des ondes de volume, induisant des parasites dans la bande de fréquence dans laquelle on veut travailler.

Ceci signifie que l'on n'est pas complètement maître du choix de l'impédance caractéristique.

On notera encore que la différence Fa-Fr entre la fréquence d'antirésonance et la fréquence de résonance est proportionnelle à un paramètre technologique appelé "$kt^2$" qui représente l'efficacité du couplage entre l'énergie électrique et l'énergie mécanique du résonateur. Ce paramètre dépend des caractéristiques physiques du résonateur, et en premier lieu de la nature du matériau piézoélectrique employé. On peut donc théoriquement fabriquer le résonateur avec une différence Fa-Fr ajustable autour d'une valeur assurée intrinsèquement par le matériau piézoélectrique.

En pratique, pour des raisons d'efficacité de fonctionnement au sein des systèmes radiofréquences, et de maîtrise technologique, les filtres du commerce facilement disponibles sont fabriqués avec des résonateurs comprenant un coefficient $kt^2$ qui est de l'ordre de 6% et avec une impédance caractéristique de l'ordre de 50 ohms à 100 ohms à la fréquence centrale pour laquelle ils ont été conçus.

Enfin, deux résonateurs de caractéristiques identiques ou presque en impédance caractéristique et en paramètre $kt^2$ mais de fréquences de résonance différentes peuvent être réalisés dans la même technologie par des moyens simples comme par exemple le dépôt d'une couche supplémentaire au-dessus de l'empilement de la figure 1 de l'un des résonateurs, l'autre étant dépourvu de cette couche supplémentaire. La couche supplémentaire est une couche diélectrique telle que du nitrure de silicium ou de l'oxyde de silicium, ou une couche métallique. Elle abaisse généralement la fréquence de résonance en ajoutant du poids à la structure sans modifier les caractéristiques électriques de la capacité équivalente $C_0$.

La figure 4 représente sous forme schématique une structure générale de dispositif de filtrage. Un filtre constitué d'une seule cellule en treillis FLT symétrique à quatre résonateurs RZs, RZs', RZp, RZp', présentant une entrée différentielle (E;E') et une sortie différentielle (S;S'), est inséré entre un circuit d'entrée et un circuit de sortie. Chacun de ces circuits peut être actif ou passif. Le circuit d'entrée est symbolisé par une source de tension Vin en série avec une impédance Zin qu'on appellera impédance de sortie du circuit d'entrée et qui peut être considérée aussi comme une "impédance de charge à l'entrée du filtre". Le circuit de sortie est symbolisé par une impédance Zout qu'on appellera impédance d'entrée du circuit de sortie et qui peut être considérée aussi comme une "impédance de charge à la sortie du filtre". Les résonateurs RZs et RZs' constituent un premier type de résonateurs dits "résonateurs série" : RZs est en série entre l'entrée E et la sortie S ; RZs' est en série entre l'entrée E' et la sortie S'. Les résonateurs RZp et RZp' constituent un deuxième type dits "résonateurs parallèles". Ils sont montés de manière croisée par rapport aux deux autres, c'est-à-dire que RZp est connecté entre l'entrée E et la sortie S', tandis que RZp' est connecté entre l'entrée E' et la sortie S. Cette disposition constitue ce qu'on appelle un filtre passif en treillis à quatre résonateurs.

Les résonateurs RZs, RZs' ont une fréquence de résonance Fr1 et une fréquence d'antirésonance Fa1 avec Fr1 < Fa1.

Les résonateurs RZp, RZp' ont une fréquence de résonance Fr2 et une fréquence d'antirésonance Fa2 avec Fr2<Fa2.

La fréquence de résonance Fr2 des résonateurs du deuxième type (résonateurs parallèles) est par convention plus faible que la fréquence de résonance Fr1 des résonateurs du premier type (résonateurs série). En vertu de la symétrie de l'agencement en treillis, et de l'application de signaux différentiels sur son entrée et sa sortie, les résonateurs parallèles pourraient occuper la place des résonateurs série sans modifier le comportement électrique de l'ensemble.

Classiquement, on s'arrangerait pour que Zin soit égale à Zout et pour que cette impédance commune soit approximativement égale à la moyenne géométrique des impédances caractéristiques des résonateurs série $Zc_s$ et des résonateurs parallèles $Zc_p$ : Zin = Zout = $(Zc_s.Zc_p)^{1/2}$. On s'arrangerait aussi pour que la fréquence d'antirésonance Fa2 des résonateurs parallèles soit approximativement égale à la fréquence de résonance Fr1 des résonateurs série. En effet, cet arrangement permet d'obtenir un filtre dont la bande passante est maximale avec un minimum de pertes d'insertion et un minimum d'ondulations dans la bande passante.

Classiquement encore, l'impédance caractéristique des résonateurs, définie plus haut comme le module de l'impédance de la capacité équivalente des résonateurs à la fréquence centrale du filtre pour lequel ils ont été conçus, prend typiquement des valeurs standard de 50 ou 100 Ohms, voire 200 Ohms.

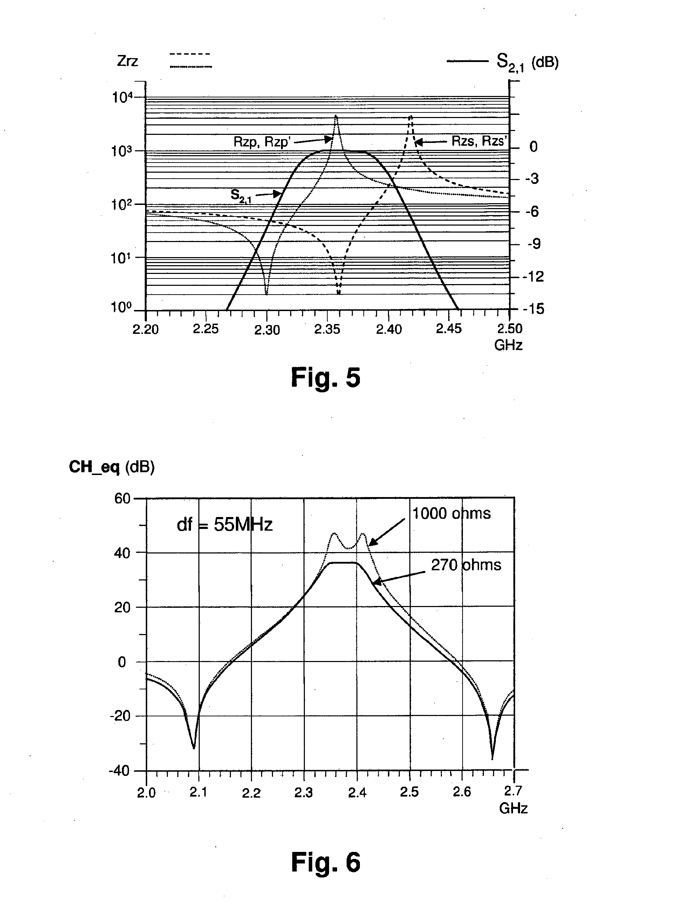

La figure 5 représente trois courbes qui illustrent le comportement d'un filtre en treillis classique à quatre résonateurs ; les résonateurs parallèles RZp et RZp' sont chargés par une couche supplémentaire qui abaisse leur fréquence de résonance. Les courbes, ayant en abscisse la fréquence, ont en ordonnée respectivement :

- le module de l'impédance (en ohms) des résonateurs RZp ou RZp' : courbe en traits pointillés référencée par rapport à l'échelle de gauche;
- le module de l'impédance (en ohms) des résonateurs RZs ou RZs' : courbe en traits tiretés référencée par rapport à l'échelle de gauche;
- le module du coefficient de transmission $S_{2,1}$ (en dB) du filtre en treillis réalisé avec les quatre résonateurs RZs, RZs', RZp et RZp' : courbe en traits pleins référencée par rapport à l'échelle de droite.

On voit que la fréquence de d'antirésonance des résonateurs RZp et RZp' a été choisie sensiblement égale à la fréquence de résonance des résonateurs RZs et RZs'. L'écart Fr1-Fr2 entre les fréquences de résonance des deux types de résonateurs est sensiblement égal à l'écart Fa2-Fr2 ou Fa1-Fr1 entre la fréquence d'anti-résonance et la fréquence de résonance d'un résonateur.

On voit aussi que le filtre a une bande passante à 3dB qui est plate et qui s'étend sur un peu plus que cet écart de fréquences.

Selon un aspect de l'invention, on donne à l'impédance de sortie du circuit d'entrée Zin et à l'impédance d'entrée du circuit de sortie du filtre Zout, c'est-à-dire aux impédances de charge en entrée et en sortie du filtre, des valeurs qui ne sont pas adaptées à l'impédance caractéristique des résonateurs.

Plus précisément, on donne à l'inverse de la partie réelle de l'admittance de sortie du circuit d'entrée Re{Yin}, Yin étant l'admittance 1/Zin de sortie du circuit d'entrée, une valeur au moins k fois supérieure à l'impédance caractéristique des résonateurs, k étant un nombre supérieur ou égal à 2. Si les impédances caractéristiques des résonateurs série et parallèle sont différentes, on considérera comme impédance caractéristique des résonateurs la moyenne géométrique des impédances caractéristiques des résonateurs série et parallèle. Par exemple si les capacités équivalentes $C_0$ des résonateurs sont en réalité des capacités différentes $C_{0s}$ et $C_{0p}$ pour les résonateurs série et parallèle respectivement, on considérera que l'impédance caractéristique Zc est $[1/(C_{0s}.C_{0p}.\omega_0^2)]^{1/2}$.

On utilise donc un circuit d'entrée (source de signal) ayant une impédance de sortie Zin, connecté aux bornes d'entrée E et E' du filtre, et un circuit de sortie (charge du filtre) d'impédance d'entrée Zout connecté aux bornes de sortie du filtre en treillis.

Selon l'invention, l'admittance de sortie Yin = 1/Zin du circuit d'entrée a une partie réelle Re{Yin} dont l'inverse 1/Re{Yin} est au moins k fois supérieur à Zc. L'admittance du circuit de sortie a une partie réelle

Re{Yout} dont l'inverse 1/Re{Yout} est également au moins k fois supérieur à Zc.

$$1/Re\{Yin\} >= k.Zc$$

$$1/Re\{Yout\} >= k.Zc$$

Le facteur multiplicatif k, au moins égal à 2, est de préférence supérieur ou égal à 5. Le nombre k est un nombre positif qui n'est pas nécessairement un entier.

Mais si on se contente d'augmenter ainsi 1/Re{Yin} et 1/Re{Yout}, on risque d'obtenir un gabarit de filtrage en fonction de la fréquence qui comporte des ondulations dans la bande pouvant dépasser plusieurs dB. Typiquement, de tels niveaux d'ondulation dans la bande ne sont pas acceptables.

La figure 6 illustre l'allure générale du module de la « charge équivalente » (en décibels) d'un même filtre pour deux valeurs différentes de l'impédance d'entrée et de sortie (270 ohms et 1000 ohms) ; on reviendra plus loin sur la notion de "charge équivalente" ; en trait plein, l'impédance d'entrée et de sortie est adaptée à l'impédance caractéristique des résonateurs du filtre alors qu'en traits pointillés l'impédance d'entrée et de sortie est largement supérieure à l'impédance caractéristique. La charge équivalente représente le gain en tension entre l'entrée du circuit d'entrée et la sortie du filtre lorsqu'on connecte le circuit d'entrée aux entrées E et E' du filtre chargé lui-même à sa sortie par une impédance Zout et lorsque la transconductance équivalente du circuit d'entrée est égale à 1. On verra plus loin que cette courbe de charge équivalente est représentative du coefficient de transmission $S_{2,1}$ du filtre.

Sur cette courbe explicative on suppose pour simplifier que l'impédance d'entrée et l'impédance de sortie sont réelles. On a indiqué à titre d'exemple une impédance de 270 ohms pour la première courbe et une impédance de 1000 ohms pour la deuxième courbe, aussi bien à l'entrée qu'à la sortie. A titre indicatif, l'écart de fréquence entre les fréquences de résonance des deux types de résonateurs employés dans ce filtre est de 55 MHz et cet écart correspond à l'écart entre la fréquence de résonance et la fréquence d'antirésonance des résonateurs. On voit que la courbe pour une impédance désadaptée de 1000 ohms présente des ondulations gênantes dans la bande utile.

Selon un aspect de l'invention, pour éliminer cette ondulation, on réduit beaucoup l'écart Fr1-Fr2 entre les fréquences de résonance des deux types de résonateurs au lieu de le conserver à peu près égal à l'écart Fa1-Fr1 (ou Fa2-Fr2) entre les fréquences de résonance et d'antirésonance d'un résonateur.

Plus précisément, on donne à Fa1-Fr1 et Fa2-Fr2 des valeurs au moins k' fois supérieurs à Fr1-Fr2, k' étant un coefficient au moins égal à 2.

$$Fa1-Fr1 >= k'.(Fr1-Fr2)$$

$$Fa2-Fr2 >= k'.(Fr1-Fr2)$$

Avec k'>= 2

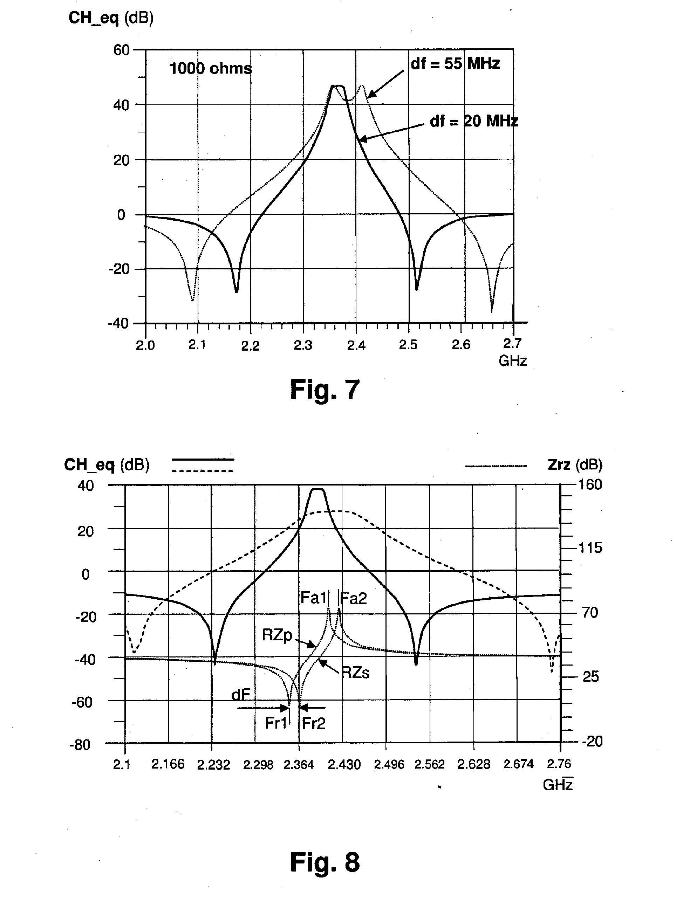

La figure 7 représente, tracée à la même échelle que la figure 6, la courbe du module de la charge équivalente (en décibels) du filtre qui peut résulter de cette opération. Sur la figure 7, la courbe en traits pointillés représente comme à la figure 6 la charge équivalente du filtre (avec ondulations) lorsque l'impédance de charge à l'entrée du filtre et l'impédance de charge à la sortie sont bien supérieures à l'impédance caractéristique des résonateurs ; la courbe en traits pleins représente la charge équivalente du filtre lorsque, partant des mêmes impédances de charge élevées en entrée et en sortie, on divise par un facteur k' d'environ 3 l'écart Fr1-Fr2 entre les fréquences de résonance des résonateurs sans toucher à leur technologie, c'est-à-dire sans toucher au paramètre $kt^2$ qui régit l'écart entre résonance et antirésonance. L'écart de fréquence df = Fr1-Fr2 passe dans cet exemple de 55 MHz à 20 MHz.

On constate alors que la charge équivalente (ou à son image, le coefficient de transmission) présente une bande passante étroite, plate, dépourvue d'ondulations dans la bande utile.

Dans cet exemple, la bande passante à 3dB est un peu supérieure à l'écart Fr1-Fr2 (entre 1,5 et 2 fois cet écart).

Le coefficient de multiplication k', au moins égal à 2, est de préférence supérieur ou égal à 3. Le nombre k' est un nombre positif qui n'est pas nécessairement un entier.

La figure 8 illustre en détail les courbes du module de la charge équivalente d'un filtre selon l'invention (en trait plein) et d'un filtre de conception classique (en trait tireté) en fonction de la fréquence. Les courbes d'impédance correspondantes des résonateurs RZp et RZs employés dans le filtre selon l'invention sont rappelées en traits pointillés avec la même échelle de fréquences en abscisse pour bien montrer l'écart de fréquence réduit entre les résonateurs des deux types. Les deux filtres comparés dans cette figure possèdent des résonateurs issus de la même technologie ($kt^2$=6%, facteur de qualité 1000, capacité principale $C_0$ 700 femtofarads). Dans le filtre de l'invention on a utilisé des impédances de charge en entrée et de charge en sortie Zin et Zout égales à 500 ohms en série avec 0,5 picofarads ; dans le filtre de conception classique, on a utilisé des impédances Zin et Zout de 100 ohms. Le premier filtre est formé avec un écart de fréquence des résonateurs d'environ 10 MHz. Le filtre de conception classique est formé avec un écart de 65 MHz correspondant approximativement à l'écart entre résonance et antirésonance.

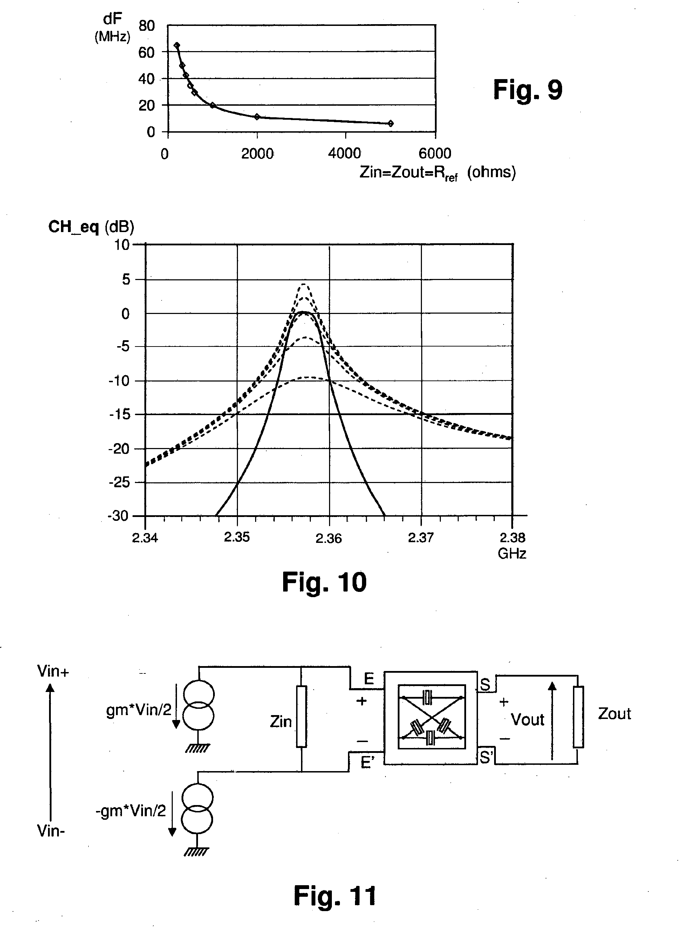

La figure 9 représente, pour un filtre utilisant des résonateurs ayant ces caractéristiques, la valeur d'écart de fréquence qu'il est souhaitable d'utiliser, en fonction de l'impédance d'entrée et de sortie connectées au filtre (supposées réelles et égales à une valeur variable $R_{ref}$) si on veut obtenir un filtre selon l'invention possédant une ondulation résiduelle dans la bande utile inférieure à 0,1 dB.

Etant donné que les impédances Zin et Zout sont maintenant largement supérieures à l'impédance caractéristique des résonateurs (qui est imposée en pratique par la technologie), on comprendra qu'on peut réduire d'autant la consommation électrique des circuits actifs d'entrée et de sortie. En effet, le fait que l'impédance de sortie du circuit électronique d'entrée soit faible implique la nécessité d'utiliser des sources de courant d'amplitude plus importante pour obtenir un même gain en tension si on considère que la tension d'alimentation des circuits est en général imposée (par exemple à 1,2 volts ou 2,5 volts). C'est également vrai pour le circuit électronique de sortie.

La comparaison des courbes des figures 6 et 7 est faite bien entendu avec les mêmes résonateurs. On comprendra qu'on peut encore ajuster la largeur de la bande passante en modifiant les caractéristiques du résonateur et notamment sa capacité principale $C_0$ et son coefficient de couplage électromécanique $kt^2$.

La figure 10 permet de montrer l'avantage de l'utilisation du dispositif de filtrage selon l'invention par rapport à un filtre actif utilisant un seul résonateur à sa fréquence de résonance ou d'antirésonance. L'utilisation d'un résonateur travaillant à sa fréquence de résonance permet d'obtenir une forte sélectivité dès lors que le résonateur a un facteur de qualité élevé. Les courbes en traits pointillés représentent les courbes de réponse en fréquence du filtre actif pour cinq facteurs de qualité différents du résonateur, la courbe la plus pointue étant la courbe obtenue avec un facteur de qualité le plus élevé (1000) et la courbe la plus plate étant celle obtenue avec un facteur de qualité le moins élevé (200). On voit clairement qu'une sélectivité forte, donc une bande passante étroite implique nécessairement que la réponse n'est pas plate dans la bande utile.

Pour comparaison, la courbe en trait plein évoque la réponse d'un filtre réalisé selon l'invention, à l'aide de résonateurs dont le coefficient de qualité vaut 1000.

Cette figure montre qu'on peut obtenir une courbe de réponse pouvant être à la fois très sélective (bande passante étroite) et beaucoup plus plate au sommet de la bande utile. La sélectivité du filtre réalisé selon l'invention est aussi nettement moins sensible à la valeur du facteur de qualité des résonateurs, paramètre qui est généralement difficile à maîtriser précisément.

Dans ce qui précède, on a considéré que l'impédance de sortie du circuit d'entrée est identique à l'impédance d'entrée du circuit de sortie à la fréquence centrale. C'est une solution préférée, mais les impédances pourraient cependant être différentes.

Par ailleurs, ces charges d'entrée et de sortie peuvent être réelles mais elles seront le plus souvent en partie ou entièrement capacitives. En effet, à l'intérieur d'un circuit de technologie CMOS, lorsqu'on cherche à optimiser le gain en tension d'une fonction, il est relativement courant que l'interface entre les blocs se fasse à des niveaux d'impédance élevés, par exemple par l'interconnexion directe sur la grille d'un transistor CMOS de faible taille. Il est donc courant de présenter des charges capacitives de faibles valeurs.

Pour mieux comprendre comment se comporte le dispositif de filtrage lorsqu'on a augmenté l'impédance en entrée et l'impédance en sortie (ou plus précisément lorsqu'on a augmenté l'inverse de la partie réelle de l'admittance en entrée ou en sortie) du filtre, on peut raisonner en terme de « charge équivalente » qui est une notion très utile au concepteur du circuit.

Pour définir la charge équivalente, le circuit d'entrée est modélisé par un circuit équivalent Norton tel que représenté à la figure 11, qui comprend 1) deux transconductances de valeur $g_m$ produisant des courants d'entrée $I=g_m Vin/2$ et $-I=-g_m Vin/2$ lorsqu'une tension différentielle Vin est appliquée entre les entrées des transconductances, et 2) une impédance de sortie différentielle Zin.

La « charge équivalente » est le gain en tension entre Vin et Vout divisé par la transconductance $g_m$, lorsque les bornes d'entrée E, E' du filtre sont connectées aux bornes d'une impédance Zin et que les bornes de sortie S, S' du filtre sont connectées aux bornes d'une impédance Zout. La tension de sortie Vout est celle développée entre les bornes S et S' du filtre. La charge équivalente représente donc le gain en tension pour une transconductance $g_m$ supposée unitaire.

Le filtre passif lui-même est caractérisé par une matrice d'impédances (matrice Z) :

Matrice Z du filtre :

$$\left| \begin{matrix} Z_{11}, & Z_{12} \\ Z_{21}, & Z_{22} \end{matrix} \right|$$

Le gain Vout/Vin peut s'exprimer comme le rapport :

$$\text{Vout/Vin} = -\,[g_m.Z_{21}.Zin.Zout]\,/\,2.[Zout.Zin + Zout.Z_{11} + Z_{22}.Zin + Z_{11}.Z_{22} - Z_{21}.Z_{12}]$$

Si la matrice est réciproque (c'est-à-dire que $Z_{11}=Z_{22}$ et $Z_{12}=Z_{21}$), ce qui est le cas d'un filtre en treillis, on peut écrire:

$$\text{Vout/Vin} = -\,[g_m.Z_{21}.Zin.Zout]\,/\,2.[Zout.Zin + Zout.Z_{11} + Z_{11}.Zin + Z_{11}^2 - Z_{21}^2]$$

Cette équation montre que le gain en tension est le produit de la transconductance $g_m$ du circuit actif d'entrée par un terme qui représente une impédance qu'on peut appeler charge équivalente CH_eq du circuit d'entrée.
La charge équivalente s'écrit alors :

$$\text{CH\_eq} = [Z_{21}.Zin.Zout]\,/\,2.[Zout.Zin + Zout.Z_{11} + Z_{11}.Zin + Z_{11}^2 - Z_{21}^2]$$

La transconductance $g_m$ du circuit d'entrée sera par exemple celle d'un transistor de sortie de ce circuit d'entrée ; or, au premier ordre, la transconductance d'un transistor varie proportionnellement à son courant de polarisation et la valeur de ce dernier a une répercussion directe sur la consommation électrique , par conséquent, on comprend que pour minimiser la consommation électrique du circuit d'entrée pour un gain en tension donné on a intérêt à réduire la transconductance. Pour un gain en tension donné, la réduction de la transconductance requiert que l'on augmente d'autant la valeur de la charge équivalente CH_eq puisque le gain en tension Vout/Vin est proportionnel à la fois à la transconductance et à la charge équivalente.
On comprend donc qu'en augmentant la charge équivalente on peut aboutir à une réduction de consommation d'énergie du circuit d'entrée si celui-ci est un circuit actif. De plus, puisque dans le contexte de la conception de circuits intégrés il est typiquement facile de réaliser des impédances élevées avec de faibles courants de polarisation, on comprend l'intérêt de travailler avec Zin et Zout élevées pour réduire davantage la consommation électrique des circuits d'entrée et de sortie si ceux-ci sont actifs.
Pour conserver la symétrie de la fonction de filtrage du filtre en treillis par rapport à la fréquence centrale, on prendra des impédances Zin et Zout égales à l'entrée et à la sortie, ou au moins égales en module (|Zin| = |Zout|).
Dans la suite on suppose que Zout=Zin.
Si les impédances Zin et Zout sont réelles et égales à une valeur résistive $R_{ref}$, on peut assez facilement exprimer la valeur du coefficient de transmission $S_{21}$ du filtre.

$$S_{21} = 2.[Z_{21}.(Zin.Zout)^{1/2}]\,/\,[Zout.Zin + Z_{11}.Zout + Z_{22}.Zin + Z_{11}.Z_{22} - Z_{12}.Z_{21}]$$

et, si on remplace Zin et Zout par $R_{ref}$, et qu'on reprend l'équation donnant la charge équivalente en l'exprimant maintenant en fonction de $S_{21}$, on trouve que la charge équivalente est :

$$\text{CH\_eq} = R_{ref}.S_{21}/4$$

$S_{21}$ étant ici la valeur du coefficient de transmission du filtre supposé chargé par Zin en entrée et Zout en sortie, donc $R_{ref}$ de chaque côté.
Ce calcul montre que le coefficient de transmission est proportionnel à la charge équivalente, et c'est pourquoi les courbes des figures 6,7,8,10 qui ont en ordonnée des charges équivalentes représentent également le coefficient de transmission du filtre.
Pour un filtre ayant de faibles pertes, ce qui est le cas lorsqu'il est conçu avec des résonateurs à fort facteur de qualité, la valeur de $S_{21}$ est une valeur proche de 1 dans la bande passante du filtre. Cela signifie donc que la charge équivalente est globalement proportionnelle à la résistance $R_{ref}$ de charge en entrée et en sortie, d'où un intérêt à augmenter cette résistance si on veut que la charge équivalente soit élevée. La charge équivalente est en effet pratiquement égale à $R_{ref}/4$ dans la bande utile (à noter qu'on s'écarte de cette valeur si $R_{ref}$ augmente beaucoup).

Un raisonnement mathématique permettrait de montrer qu'on ne change pas la réponse en transmission $S_{21}$ (calculée par rapport à la référence $R_{ref}$) si on multiplie la résistance $R_{ref}$ par un coefficient et que parallèlement on utilise des résonateurs de capacité Co divisée par ce même coefficient. Mais, tel qu'expliqué plus haut, on ne peut pas réduire indéfiniment la taille du résonateur sans perturber la résonance, et de plus cela ne réduirait pas la bande passante.

On pourrait aussi montrer qu'on ne changerait pas la réponse en transmission $S_{21}$ (calculée par rapport à la référence $R_{ref}$) si on multipliait par deux ou trois (ou plus) la résistance $R_{ref}$ et si on mettait en série deux ou trois (ou plus) résonateurs au lieu d'un seul dans chaque branche du filtre en treillis ; mais cette multiplication du nombre de résonateurs a un coût et entraîne une augmentation de l'encombrement du filtre, et là encore elle ne réduirait pas la bande passante du filtre.

En modifiant l'écart de fréquences entre les deux résonateurs en même temps qu'on augmente $R_{ref}$, on aboutit à la fois à une possibilité de réduire la consommation des circuits actifs d'entrée et/ou de sortie, et à une bande passante réduite mais sans ondulation, et ceci sans avoir besoin de réduire le coefficient de couplage électromécanique des résonateurs comme on le ferait dans une conception classique de filtre à bande étroite à résonateurs.

Les explications qui précèdent ont été données pour simplifier en supposant que les impédances en entrée et en sortie Zin et Zout sont résistives. Mais elles peuvent être purement capacitives ou complexes. Le cas typique d'une impédance capacitive est le cas où la sortie du filtre en treillis est reliée aux grilles de transistors MOS.

On peut montrer que si l'impédance Z=Zin=Zout est complexe, on peut se ramener au cas précédent d'une impédance réelle avec $R_{ref}=1/Re\{1/Z\}$, à la condition de considérer virtuellement qu'on a placé une capacité de valeur $Im\{1/Z\}/(2\pi f)$, où f est la fréquence, en parallèle de chacun des quatre résonateurs du filtre en treillis. Cette capacité virtuelle a pour effet de réduire virtuellement le coefficient de couplage $kt^2$ des résonateurs et d'augmenter leur capacité principale $C_0$, mais le raisonnement en termes de charge équivalente reste le même.

C'est pourquoi l'invention propose, dans le cas d'impédances de charge complexes en entrée et en sortie, de considérer non pas le module desimpédances de charge en entrée et en sortie connectées aux bornes du filtre en treillis, mais plus précisément l'inverse de la partie réelle Re{Yin} de l'admittance en entrée et l'inverse de la partie réelle Re{Yout} de l'admittance en sortie : ce sont ces valeurs qui doivent être supérieures à k fois la valeur de l'impédance caractéristique Zc des résonateurs, k étant un nombre au moins égal à 2, comme indiqué précédemment.

L'invention peut être appliquée notamment dans des récepteurs à haute fréquence intermédiaire (de l'ordre du Gigahertz). Dans ce type de récepteur, le signal utile capté par l'antenne, à fréquence UHF par exemple, est mélangé avec un signal issu d'un oscillateur local à fréquence variable. Le signal résultant du mélange et éventuellement amplifié est filtré par un filtre à fréquence intermédiaire à bande étroite réalisé selon les principes de la présente invention. Ce filtre peut avoir plusieurs fonctions : sélection de la bande correspondant au canal pour réduire les contraintes de sélectivité et de linéarité des étages suivants de la chaîne de réception ; ou encore atténuation d'une bande image d'une seconde fréquence intermédiaire ; ou encore atténuation de bandes de repliement de spectre lors d'un processus d'échantillonnage ou de décimation.

Ensuite, le signal utile, maintenant situé en fréquence intermédiaire, peut être translaté vers la bande de base ou vers une deuxième fréquence intermédiaire plus basse que la première. Cette translation peut se faire par exemple à l'aide d'un deuxième mélangeur ou encore par sous-échantillonnage à une fréquence plus faible que la première fréquence intermédiaire. Dans ces deux cas, le dispositif de filtrage peut être utilisé pour éliminer des signaux qui pourraient se replier vers la bande utile. Dans le cas d'une translation de fréquence par sous-échantillonnage, le dispositif de filtrage est placé entre le mélangeur qui produit le signal à la première fréquence intermédiaire et le circuit de sous-échantillonnage, ce dernier constituant la charge du filtre en treillis.

L'invention peut également être appliquée pour un récepteur à très faible consommation pour application de "réveil". Un récepteur de réveil est un récepteur radiofréquence à performances réduites mais dont la consommation électrique est très faible. Il est utilisé en complément d'un récepteur plus performant dont la consommation est plus importante et qui ne doit donc fonctionner que dans des intervalles de temps limités afin de préserver les ressources énergétiques. Le récepteur de réveil peut rester allumé en permanence ou est allumé plus régulièrement que le récepteur principal. Il peut être utilisé dans un réseau de capteurs pour réduire le temps de latence dans la communication, simplifier la synchronisation, et optimiser le débit. L'utilisation d'un filtre conçu pour réduire la consommation est donc particulièrement appropriée pour ce type de récepteur.

L'homme de l'art pourra imaginer d'autres modes de réalisation de la présente invention.

Entre autres, on pourra utiliser divers types de résonateur présentant une fréquence de résonance et une fréquence d'antirésonance, par exemple des résonateurs à ondes acoustiques de surface (SAW), des résonateurs à ondes acoustiques de volume (BAW), des résonateurs ... (LAMB), des résonateurs de type MEMs.

De plus, les filtres en treillis peuvent être constitués de plusieurs cellules en treillis ou autres.

En outre, le dispositif selon l'invention peut avantageusement être réalisé dans une même puce électronique ou un même assemblage de puces, en utilisant par exemple les techniques d'assemblage de puces « en 3D ».

**Revendications**

1. Dispositif de filtrage comportant un circuit électronique d'entrée ayant une admittance de sortie Yin, un circuit électronique de sortie ayant une admittance d'entrée Yout, un filtre présentant une entrée différentielle reliée au circuit d'entrée, une sortie différentielle reliée au circuit de sortie, le filtre comprenant plusieurs résonateurs de deux types (RZs,RZs' ; RZp, RZp') connectés entre l'entrée et la sortie du filtre, les résonateurs du premier type ayant une fréquence de résonance Fr1 et une fréquence d'antirésonance Fa1, et les résonateurs du deuxième type ayant une fréquence de résonance Fr2 et une fréquence d'antirésonance Fa2 respectivement différentes de Fr1 et Fa1, **caractérisé en ce que** l'inverse de la partie réelle de l'admittance Yin (1/Re{Yin}) et l'inverse de la partie réelle de l'admittance Yout (1/Re{Yout}) sont supérieurs à k fois la valeur de la moyenne géométrique des impédances caractéristiques (Zc) des résonateurs, k étant un nombre au moins égal à 2, et **en ce que** les différences de fréquence Fa1-Fr1 et Fa2-Fr2 sont supérieures à k' fois la valeur absolue de la différence Fr1-Fr2, k' étant un nombre au moins égal à 2.

2. Dispositif selon la revendication 1, **caractérisé en ce que** la différence entre la fréquence d'antirésonance et la fréquence de résonance est sensiblement la même pour les résonateurs des deux types.

3. Dispositif selon l'une des revendications 1 et 2, **caractérisé en ce que** la partie réelle Re{Yin} de l'admittance de sortie du circuit d'entrée est égale à la partie réelle Re{Yout} de l'admittance d'entrée du circuit de sortie.

4. Dispositif selon l'une des revendications 1 à 3, **caractérisé en ce que** le nombre k est supérieur ou égal à 5.

5. Dispositif selon l'une des revendications 1 à 4, **caractérisé en ce que** le nombre k' est supérieur ou égal à 3.

6. Dispositif selon l'une des revendications 1 à 5, **caractérisé en ce que** le filtre comprend au moins une cellule en treillis constituée de quatre résonateurs, deux résonateurs du premier type (RZs ; RZs') et deux résonateurs du second type (RZp ; Rzp'), l'entrée différentielle ayant deux bornes d'entrée E et E', la sortie différentielle du filtre ayant deux bornes de sortie S et S', un résonateur du premier type (RZs) étant placé entre l'entrée E et la sortie S, un autre résonateur du premier type (RZs') étant placé entre l'entrée E' et la sortie S', un résonateur de second type (Rzp) étant placé entre l'entrée E et la sortie S' et un autre résonateur du second type (Rzp') étant placé entre l'entrée E' et la sortie S..

7. Dispositif selon l'une des revendications 1 à 6, **caractérisé en ce que** les résonateurs sont des résonateurs piézoélectriques à ondes acoustiques de volume ou à ondes acoustiques de surface.

**Patentansprüche**

1. Filtervorrichtung, die Folgendes umfasst: eine elektronische Eingangsschaltung mit einer Ausgangsadmittanz Yin, eine elektronische Ausgangsschaltung mit einer Eingangsadmittanz Yout, ein Filter, das einen mit der Eingangsschaltung verbundenen Differentialeingang aufweist, einen Differentialausgang, der mit der Ausgangsschaltung verbunden ist, wobei das Filter mehrere Resonatoren von zwei Typen (RZs, RZs', RZp, RZp') umfasst, die zwischen dem Eingang und dem Ausgang des Filters geschaltet sind, wobei die Resonatoren des ersten Typs eine Resonanzfrequenz Fr1 und eine Antiresonanzfrequenz Fa1 haben und die Resonatoren des zweiten Typs eine Resonanzfrequenz Fr2 und eine Antiresonanzfrequenz Fa2 haben, die sich von Fr1 bzw. Fa1 unterscheiden, **dadurch gekennzeichnet, dass** die Umkehr des Realteils der Admittanz Yin (1/Re{Yin}) und die Umkehr des Realteils der Admittanz Yout (1/Re{Yout}) mehr als k Mal größer sind als der Wert des geometrischen Mittels der charakteristischen Impedanzen (Zc) der Resonatoren, wobei k eine ganze Zahl wenigstens gleich 2 ist, und dadurch, dass die Frequenzdifferenzen Fa1-Fr1 und Fa2-Fr2 mehr als k' Mal größer als der Absolutwert der Differenz Fr1-Fr2 ist, wobei k' eine Zahl wenigstens gleich 2 ist.

2. Vorrichtung nach Anspruch 1, **dadurch gekennzeichnet, dass** die Differenz zwischen der Antiresonanzfrequenz und der Resonanzfrequenz für die Resonatoren der beiden Typen im Wesentlichen gleich ist.

3. Vorrichtung nach einem der Ansprüche 1 und 2, **dadurch gekennzeichnet, dass** der Realteil Re{Yin} der Ausgangsadmittanz der Eingangsschaltung gleich dem Realteil Re{Yout} der Eingangsadmittanz der Ausgangsschaltung ist.

**4.** Vorrichtung nach einem der Ansprüche 1 bis 3, **dadurch gekennzeichnet, dass** die Zahl k gleich oder größer als 5 ist.

**5.** Vorrichtung nach einem der Ansprüche 1 bis 4, **dadurch gekennzeichnet, dass** die Zahl k' gleich oder größer als 3 ist.

**6.** Vorrichtung nach einem der Ansprüche 1 bis 5, **dadurch gekennzeichnet, dass** das Filter wenigstens eine gitterförmige Zelle umfasst, die von vier Resonatoren gebildet wird, zwei Resonatoren des ersten Typs (RZs; RZs') und zwei Resonatoren des zweiten Typs (RZp; Rzp'), wobei der Differentialeingang zwei Eingangsanschlüsse E und E' hat, wobei der Differentialeingang des Filters zwei Ausgangsanschlüsse S und S' hat, wobei ein Resonator des ersten Typs (RZs) zwischen dem Eingang E und dem Ausgang S platziert ist, wobei ein anderer Resonator des ersten Typs (RZs') zwischen dem Eingang E' und dem Ausgang S' platziert ist, wobei ein Resonator des zweiten Typs (Rzp) zwischen dem Eingang E und dem Ausgang S' platziert ist und ein anderer Resonator des zweiten Typs (Rzp') zwischen dem Eingang E' und dem Ausgang S' platziert ist.

**7.** Vorrichtung nach einem der Ansprüche 1 bis 6, **dadurch gekennzeichnet, dass** die Resonatoren piezoelektrische Resonatoren mit akustischen Volumenwellen oder akustischen Oberflächenwellen sind.

**Claims**

**1.** Filter device including an input electronic circuit having an output admittance Yin, an output electronic circuit having an input admittance Yout, a filter having a differential input connected to the input circuit and a differential output connected to the output circuit, the filter comprising a plurality of resonators of two types (RZs, RZs'; RZp, RZp') connected between the input and the output of the filter, the resonators of the first type having a resonant frequency Fr1 and an antiresonant frequency Fa1 and the resonators of the second type having a resonant frequency Fr2 and an antiresonant frequency Fa2 respectively different from Fr1 and Fa1, **characterized in that** the reciprocal of the real part of the admittance Yin (1/Re{Yin}) and the reciprocal of the real part of the admittance Yout (1/Re{Yout}) are greater than k times the value of the geometric mean of the characteristic impedances (Zc) of the resonators, k being a number at least equal to 2, and **in that** the frequency differences Fa1-Fr1 and Fa2-Fr2 are greater than k' times the absolute value of the difference Fr1-Fr2, k' being a number at least equal to 2.

**2.** Device according to Claim 1, **characterized in that** the difference between the antiresonant frequency and the resonant frequency is substantially the same for the resonators of both types.

**3.** Device according to either of Claims 1 and 2, **characterized in that** the real part Re{Yin} of the output admittance of the input circuit is equal to the real part Re{Yout} of the input admittance of the output circuit.

**4.** Device according to any one of Claims 1 to 3, **characterized in that** the number k is greater than or equal to 5.

**5.** Device according to one of Claims 1 to 4, **characterized in that** the number k' is greater than or equal to 3.

**6.** Device according to any one of Claims 1 to 5, **characterized in that** the filter comprises at least one lattice cell constituted of four resonators, two resonators of the first type (RZs; RZs') and two resonators of the second type (RZp; Rzp'), the differential input having two input terminals E and E', the differential output of the filter having two output terminals S and S', a resonator of the first type (RZs) being placed between the input E and the output S, another resonator of the first type (RZs') being placed between the input E' and the output S', a resonator of the second type (Rzp) being placed between the input E and the output S' and another resonator of the second type (Rzp') being placed between the input E' and the output S.

**7.** Device according to any one of Claims 1 to 6, **characterized in that** the resonators are bulk acoustic wave or surface acoustic wave piezoelectric resonators.

**Fig. 1**

**Fig. 2**

**Fig. 3**

**Fig. 4**

**Fig. 5**

**Fig. 6**

Fig. 7

Fig. 8

**Fig. 9**

**Fig. 10**

**Fig. 11**